# EUROPEAN PATENT APPLICATION

(11) **EP 4 826 445 A1**
(43) Date of publication of application: **21.10.2026**
(21) Application number: 25189844.1
(22) Date of filing: 16.07.2025
(51) Int. Cl.: G03F 1/26, G03F 1/24

(54) **PHASE SHIFT BLANKMASK AND PHOTOMASK FOR EUV LITHOGRAPHY**

(30) Priority: 15.04.2025 KR 20250048516
(71) Applicant: S&S Tech Co., Ltd., Daegu 42714 (KR)
(72) Inventor: YUN, Jong-Won, 42714 Daegu (KR); PARK, Min-Kyu, 42714 Daegu (KR); WOO, Mi-Kyung, 42714 Daegu (KR); YANG, Chul-Kyu, 42714 Daegu (KR); KIM, Yong-Dae, 42714 Daegu (KR)
(74) Representative: ABG Intellectual Property Law, S.L.

(57) **Abstract**

A phase shift blankmask for EUV lithography includes a phase shift film. The phase shift film consists of a single layer containing chromium (Cr), niobium (Nb), and nitrogen (N), has a composition ratio of Cr:Nb = 6.5:3.5 ~ 5.5:4.5, and has an extinction coefficient (k) exceeding 0.023 and a relative reflectance of less than 9% for an EUV wavelength of 13.5nm. The phase shift film has a total content of Cr and Nb exceeding 60at% and less than 90at%, and a nitrogen (N) content exceeding 10at% and less than 40at%. The phase shift film has a thickness exceeding 47nm and less than 57nm. Since the phase shift film uses CrNb as the main material, it has various advantages such as low surface roughness and good etching characteristics of this material. Additionally, despite the low extinction coefficient (k) of CrNb material, a relative reflectance of less than 9%, less than 8.5%, and further less than 8% can be implemented even with a small thickness.

## Description

### CROSS-REFERENCE TO RELATED APPLICATIONS

This application is based on and claims priority under 35 U.S.C. §119 to Korean Patent Application No. 10-2025-0048516 filed on April 15, 2025 in the Korean Intellectual Property Office, the disclosure of which is incorporated by reference herein in its entirety.

### BACKGROUND

### Field

The present invention relates to a blankmask and a photomask for EUV lithography, having a phase shift film.

### Description of the Related Art

Recent lithography technology for semiconductor manufacturing has been advancing from ArF, ArFi MP(Multiple) Lithography to EUV Lithography technology. EUV Lithography technology uses a 13.5nm exposure wavelength, enabling improved resolution and process simplification, making it a prominent technology for manufacturing semiconductor devices below 10nm. EUV lithography uses reflective type photomasks with a reflective optical system.

The blankmask serves as the raw material for the photomask, which comprises two films on a substrate: a reflective film that reflects EUV light and an absorber film that absorbs EUV light. The photomask is manufactured by patterning the absorber film of this blankmask, utilizing the contrast difference between the reflectance of the reflective film and the absorber film to form patterns on the wafer.

Recently, there is a demand for developing blankmasks for semiconductor devices below 10nm, specifically 7nm, 5nm, and even below 3nm. However, in processes below 5nm, such as 3nm processes, using current binary photomasks would require Double Patterning Lithography (DPL) technology. Accordingly, the development of phase shift blankmasks, which can achieve higher resolution compared to binary blankmasks with absorber films, is being attempted.

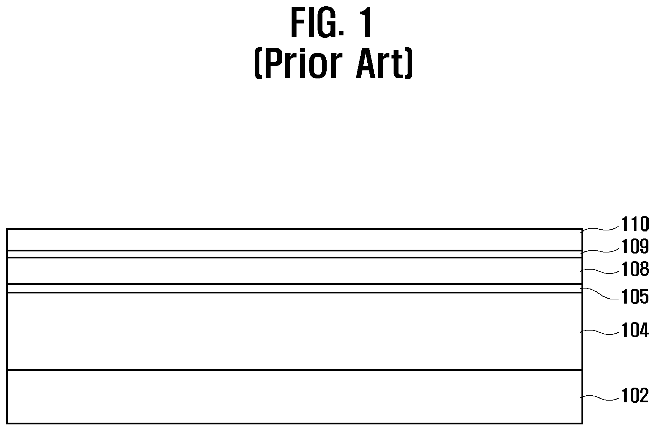

FIG. 1 illustrates the basic structure of a phase shift blankmask for extreme ultraviolet lithography. The phase shift blankmask for extreme ultraviolet lithography consists of a substrate 102, a reflective film 104 formed on the substrate 102, a capping film 105 formed on the reflective film 104, a phase shift film 108 formed on the capping film 105, a hard mask film 109 formed on the phase shift film 108, and a resist film 110 formed on the hard mask film 109. In this structure of an EUV lithography phase shift blankmask, the phase shift film 108 is preferably made with materials that facilitate photomask fabrication and provide excellent performance during wafer printing. Additionally, the phase shift film 108 must meet the requirements for various properties such as reflectance.

The material for the phase shift film 108 has traditionally employed tantalum (Ta) as the main material. However, phase shift film 108 containing Ta as the main material has a very low reflectance with a relative reflectance of 5% or less, making it difficult to achieve high wafer printing effects. Accordingly, there has been a demand for the development of new materials suitable for implementing high reflectance.

As an example of a phase shift film 108 that can implement high reflectance, the applicant of this invention has previously filed Korean Patent Application No. 2021-0077682 (Phase Shift Blankmask and Photomask for Extreme Ultraviolet Lithography). In the invention of this patent application, the phase shift film 108 is composed of CrNbN and is configured to have a composition ratio of Cr:Nb:N = 30~40at%:20~50at%:10~50at%. The alloy of Cr and Nb has a lower extinction coefficient (k) compared to Ta. Therefore, the phase shift film 108 of this patent application can implement higher reflectance compared to Ta phase shift films, showing a relative reflectance of 9~15%. Furthermore, CrNb phase shift films 108 provide various advantages such as etching using chlorine gas (Cl₂) and low surface roughness. Also, Nb has a lower refractive index compared to Ta, providing the advantage of easily implementing the required phase shift amount for the phase shift film 108.

Generally, higher reflectance of the phase shift film 108 improves wafer printing performance. However, for patterns with repetition and symmetry closer to random, such as in logic applications, excessively high reflectance is not desirable due to sidelobe effects, and therefore, a lower reflectance than that in the aforementioned patent application is required. Generally, a relative reflectance of less than 9% can be applied to the formation of patterns with less symmetry, and if it is even lower, for example, less than 8.5% or less than 8%, it can be applied more usefully.

To meet this reflectance limitation while using CrNb as the main material, the thickness of the phase shift film 108 must be very thick, over 60nm. However, in EUV lithography photomasks, the EUV exposure light enters at an angle of 6-7° from the direction perpendicular to the substrate 102, so if the phase shift film 108 is too thick, the precision of the exposed pattern deteriorates due to the shadowing effect. Therefore, a solution is needed for CrNb-based phase shift films 108 to maintain a thin thickness while meeting the reflectance limitation.

### SUMMARY

The present invention was devised to solve the aforementioned problems. The purpose of this invention is to provide an EUV blankmask with a phase shift film that has the advantages of using CrNb as the main material, while also preventing thickness increase while suppressing the reflectance from being excessively high.

The present invention provides a phase shift blankmask for extreme ultraviolet lithography comprising: a substrate; a reflective film formed on the substrate; a capping film formed on the reflective film; and a phase shift film formed on the capping film. The phase shift film consists of a single layer containing chromium (Cr), niobium (Nb), and nitrogen (N), has a composition ratio of Cr:Nb = 6.5:3.5 ~ 5.5:4.5, and has an extinction coefficient (k) exceeding 0.023 and a relative reflectance of less than 9% for an EUV wavelength of 13.5nm.

The phase shift film has a total content of Cr and Nb exceeding 60at% and less than 90at%, and has a nitrogen (N) content exceeding 10at% and less than 40at%.

The phase shift film can further contain oxygen (O). In this case, the phase shift film has a total content of Cr and Nb exceeding 50at% and less than 80at%, has a nitrogen (N) content exceeding 10at% and less than 30at%, and has an oxygen (O) content exceeding 10at% and less than 20at%.

In order to implement the relative reflectance less than 9%, the phase shift film has a thickness exceeding 47nm and less than 57nm. In order to implement the reflectance less than 8.5%, the phase shift film has a thickness exceeding 47.5nm and less than 57nm. In order to implement the reflectance less than 8%, the phase shift film has a thickness exceeding 47.8nm and less than 57nm.

In such a situation, in order to get NILS of 2.05 or more in the horizontal direction, the phase shift film has a thickness less than 54.8nm. In order to get NILS of 2.05 or more in the horizontal and viatical directions, the phase shift film has a thickness exceeding 50.8nm.

The phase shift blankmask of the present invention can further comprise a hard mask film. The hard mask film is formed on the phase shift film, contains tantalum (Ta) and oxygen (O), has a Ta content of less than 50at%, and has an extinction coefficient (k) exceeding 0.020. The hard mask film has a thickness of less than 5nm, and preferably has a thickness of 2±1nm.

When such a hard mask film is equipped, in order to implement the relative reflectance less than 9%, the phase shift film has a thickness exceeding 45nm and less than 55nm. In order to implement the reflectance less than 8.5%, the phase shift film has a thickness exceeding 45.5nm and less than 55nm. In order to implement the reflectance less than 8%, the phase shift film has a thickness exceeding 45.8nm and less than 55nm.

In such a situation, in order to get NILS of 2.05 or more in the horizontal direction, the phase shift film has a thickness less than 52.8nm. In order to get NILS of 2.05 or more in the horizontal and vertical directions, the phase shift film has a thickness exceeding 48.8nm.

According to another aspect of the present invention, a photomask fabricated using the phase shift blankmask for extreme ultraviolet lithography is provided.

According to the present invention, since the phase shift film uses CrNb as the main material, it has various advantages such as low surface roughness and good etching characteristics of this material. Additionally, despite the high reflectance of CrNb material, it is possible to implement a relative reflectance of less than 8%, less than 8.5%, or less than 8%, so there is no need to increase the thickness to meet the reflectance limitation. Accordingly, both sidelobe effect and shadowing effect can be prevented. Using a photomask made with this blankmask, excellent resolution can be achieved when fabricating patterns below 7nm.

### BRIEF DESCRIPTION OF THE DRAWINGS

FIG. 1 is a diagram illustrating the basic structure of a phase shift blankmask for extreme ultraviolet lithography.
FIG. 2 is a diagram illustrating the change in reflectance according to the thickness of a film containing a composition ratio of Cr:Nb = 4:6.
FIG. 3 is a graph illustrating the change in reflectance according to the thickness of a phase shift film containing a composition ratio of Cr:Nb = 6:4 according to the embodiment of this invention.
FIG. 4 is a graph showing the NILS measured in the horizontal direction of the stacked structure of the phase shift film and the hard mask film under the same conditions as in FIG. 3.
FIG. 5 is a graph showing the NILS measured in the horizontal direction of the stacked structure of the phase shift film and the hard mask film under the same conditions as in FIG. 3.

### DETAILED DESCRIPTION OF EXEMPLARY EMBODIMENTS

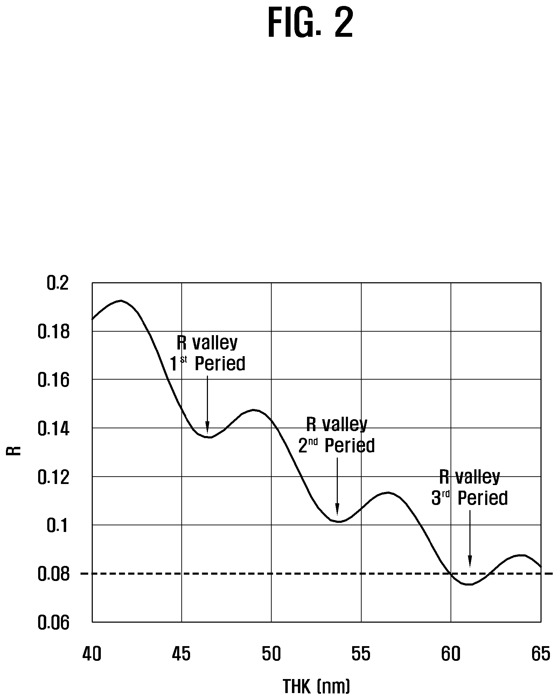

The blankmask of this invention has the same basic film structure as the blankmask in FIG. 1. Therefore, in the following description of this invention, redundant explanations for configurations already explained with reference to FIG. 1 will be omitted, and such explanations are incorporated as descriptions of the basic configuration of this invention. In the following description of this invention, the same reference numerals used in FIG. 1 are cited for the same components for convenience of explanation. As shown in FIG. 1 and FIG. 2, the blankmask of this invention includes a substrate 102, a reflective film 104, a capping film 105, and a phase shift film 108. A hard mask film 109 is formed on the phase shift film 108.

The phase shift film 108 of this invention has a relative reflectance of less than 9%, preferably has a relative reflectance of less than 8.5%, and more preferably has a reflectance of less than 8%. Here, the relative reflectance refers to the ratio of the absolute reflectance of the phase shift film 108 compared to the absolute reflectance of the reflective film 104 including the capping film 105. In the following description, "reflectance" refers to relative reflectance. The phase shift film 108 has a phase shift amount of 1~1.3π, and preferably has a phase shift amount of 1~1.2π, for example, which maximizes the effect of NILS (Normalized Image Log Slope) during Wafer Printing.

To implement such reflectance, the phase shift film 108 of this invention is configured to have an extinction coefficient (k) exceeding 0.023 for an EUV wavelength of 13.5nm. The composition material and composition ratio of each composition material of the phase shift film 108 are controlled to satisfy the ranges of such reflectance, phase shift amount, and extinction coefficient (k).

The phase shift film 108 of this invention is composed of chromium (Cr) and niobium (Nb), and consists of a single layer. As mentioned earlier, CrNb alloy has a low extinction coefficient (k), resulting in high reflectance. Since Cr has a higher extinction coefficient (k) than Nb, in order to limit reflectance as in this invention, it is preferable to increase the content of Cr and decrease the content of Nb.

The phase shift film 108 of this invention is configured to have a composition ratio of Cr:Nb = 6.5:3.5 ~ 5.5:4.5. If the Cr content becomes lower than Cr:Nb = 5.5:4.5, it is difficult to obtain an extinction coefficient (k) exceeding 0.023 as described above. When etching the phase shift film 108, it is preferable to use an etching gas containing only chlorine (Cl₂) without oxygen (O₂) to prevent oxidation of the capping film 105 below. Since the etching speed slows down as Cr increases in CrNb alloy, to secure sufficient etching speed in an etching gas containing only chlorine (Cl₂), it is preferable that the Cr content be lower than Cr:Nb = 6.5:3.5. Therefore, it is preferable that the composition ratio of Cr and Nb is set to the above range.

The phase shift film 108 of this invention contains nitrogen (N). By including nitrogen (N), the etching rate can be improved, enhancing the pattern profile. Also, nitrogen (N) amorphizes the film crystallinity of the phase shift film 108, making the pattern profile excellent when forming patterns. Additionally, as nitrogen (N) has a lower atomic weight compared to Cr and Nb, it functions to lower the surface roughness of the film after sputtering. This makes it easier to control diffuse reflection occurring on the surface of the phase shift film 108. Considering this, the nitrogen (N) content of the phase shift film 108 is preferably more than 10at%. However, if the nitrogen (N) content increases, the phase shift film 108 is more likely to deteriorate due to cleaning solutions such as SPM, SC-1, TMAH, etc. during cleaning, and it becomes difficult to obtain an extinction coefficient (k) exceeding 0.023. Considering this, the nitrogen (N) content is preferably less than 40at%. In this case, the total content of Cr and Nb in the CrNbN phase shift film 108 becomes more than 60at% and less than 90at%.

The phase shift film 108 of this invention may further include oxygen (O). By including oxygen (O), the etching rate of the phase shift film 108 is improved. Chromium (Cr) is easily etched when using chlorine-based gas containing oxygen (O₂) as the etching gas, but in this case, there is a disadvantage that the capping film 105 is oxidized. In this invention, by adopting an alloy of chromium (Cr) and niobium (Nb) as the composition material of the phase shift film 108, it is possible to etch the phase shift film 108 even using chlorine-based gas without oxygen (O₂). However, the etching rate improved by niobium (Nb) alone may be insufficient. When oxygen (O) is included in the phase shift film 108, the etching rate by chlorine-based gas is further improved, so it can implement a faster etching rate in addition to the etching rate improvement by niobium (Nb). For effective etching rate improvement, the oxygen (O) content of the phase shift film 108 is preferably more than 10at%. However, if the oxygen (O) content is above a certain level, metal oxide is rapidly formed, reducing the density of the film. If a film is formed of a certain material, the optical constant of the film for the EUV wavelength is proportional to the density of the film. If the oxygen (O) content exceeds 20at%, it is difficult to obtain an extinction coefficient (k) of the phase shift film 108 exceeding 0.023. Considering this, the oxygen (N) content is preferably less than 20at%.

Meanwhile, when including both nitrogen (N) and oxygen (O), the nitrogen (N) content of the phase shift film 108 can be configured to be more than 10at% and less than 30at%. In this case, the total content of nitrogen (N) and oxygen (O) is more than 20at% and less than 50at%, so the total content of Cr and Nb becomes more than 50at% and less than 80at%. As oxygen (O) has less effect on reducing the extinction coefficient (k) for CrNb phase shift film 108 compared to nitrogen (N), when the CrNb phase shift film 108 contains both nitrogen (N) and oxygen (O), implementing an extinction coefficient (k) exceeding 0.023 is possible as long as the total content of CrNb exceeds 50at%.

The hard mask film 109 is used as a mask for etching the phase shift film 108 after being patterned by the resist film 110. The hard mask film 109 is not an essential film and is formed optionally as needed. However, for the efficiency of the etching process of the phase shift film 108, it is generally preferable to have a hard mask film 109. Since the phase shift film 108 containing CrNb is etched by chlorine-based etching gas, the hard mask film 109 is formed of a material that is etched by fluorine-based etching gas. As an example, this invention illustrates that the hard mask film 109 is composed of a film containing tantalum (Ta) and oxygen (O). Tantalum (Ta) is etched by chlorine-based etching gas when it does not contain oxygen (O), but when it contains oxygen (O), it is etched by fluorine-based etching gas. The hard mask film 109 may additionally include one or more of boron (B) and nitrogen (N). For example, the hard mask film 109 can be formed of one of TaO, TaON, TaOB, or TaOBN. Such a hard mask film 109 has a minimum thickness that can perform the etching mask function, and preferably has a thickness of less than 5nm, more preferably a thickness of 2±1nm.

For the TaO hard mask film 109 to have good etching characteristics against fluorine-based etching gas, the oxygen (O) content must be high, and accordingly, the Ta content must be reduced. Preferably, to secure sufficient etching performance, it is configured so that the Ta content is less than 50at%. In this case, the extinction coefficient (k) of the hard mask film 109 becomes similar to that of the phase shift film 108. Therefore, in the viewpoint of the extinction coefficient (k), the hard mask film 109 functions similarly to the phase shift film 108. Preferably, the hard mask film 109 is configured to have an extinction coefficient (k) exceeding 0.020, and more preferably exceeding 0.023.

The hard mask film 109 is generally removed after the etching of the phase shift film 108 is completed, but in some cases, it remains without being removed and is used as part of the pattern in the photomask. That is, after the etching of the phase shift film 108 is completed, unless an additional etching process using fluorine (F)-based gas is performed, the hard mask film 109 remains on top of the phase shift film 108 after the photomask fabrication is completed. In this case, the hard mask film 109 also functions as part of the phase shift film 108, resulting in an increase in the thickness of the phase shift film 108 by the thickness of the hard mask film 109.

In the following description referring to FIG. 2 to FIG. 5 for this invention, the results were tested with a hard mask film 109 containing TaO and having a thickness of 2nm formed on top of the phase shift film 108. That is, the following description of this invention assumes that the pattern of the hard mask film 109 containing TaO and having a thickness of 2nm remains in the photomask. Accordingly, in the following description, when referring to the properties of the entire stacked structure 108 and 109 of the phase shift film 108 and the hard mask film 109, it is expressed as "reflectance of the stacked structure 108 and 109", "extinction coefficient of the stacked structure 108 and 109", "NILS of the stacked structure 108 and 109", and so on. Expressions simply written as "reflectance", "extinction coefficient", "NILS" refer to the respective properties in the stacked structure 108 and 109 in the description of embodiments including the hard mask film 109, and refer merely to the respective properties in the phase shift film 108 in the description of embodiments not including the hard mask film 109.

The following examines the specific details for deriving the detailed configuration of the phase shift film 108 of this invention based on the technical concept described above.

In the invention of Korean Patent Application No. 2021-0077682 described as the prior art, it is configured to have a composition ratio of Cr:Nb:N = 30~40at%:20~50at%:10~50at%. However, since Cr has a larger extinction coefficient (k) than Nb, when actually implementing products in this patent application invention, it is configured to have a higher content of Nb than Cr to implement a high reflectance of 9~15%. The typical composition ratio in the actual implementation of this patent application invention is Cr:Nb = 4:6.

FIG. 2 is a diagram illustrating the change in relative reflectance according to the thickness of a film containing a composition ratio of Cr:Nb = 4:6. Since the phase shift film 108 of this invention proposes a configuration of Cr:Nb = 6.5:3.5 ~ 5.5~4.5, FIG. 2 is shown to show the reflectance characteristics of the CrNb phase shift film of the aforementioned patent application containing Cr:Nb = 4:6 for comparison with this invention. In FIG. 2, the horizontal axis represents the thickness of the CrNb film, and the vertical axis represents the reflectance of the stacked structure of the CrNb film and a 2nm thick TaO film. As the thickness of the CrNb film increases, the reflectance decreases, but the overall change shows a pattern of decreasing in the form of a wave with a period of about 7nm, which is the half-wavelength (λ/2) of the 13.5nm wavelength EUV exposure light. As can be seen from FIG. 2, for the reflectance to be less than 9%, the CrNb film must have a thickness of at least 58.5nm or more, resulting in the sum of the thicknesses of the CrNb film and the TaO film becoming very thick, at least 60.5nm or more. Further, for the reflectance to be less than 8%, the CrNb film must have a thickness of at least 60nm or more, resulting in the sum of the thicknesses of the CrNb film and the TaO film becoming very thick, at least 62nm or more. Meanwhile, as shown in FIG. 2, the valleys in the reflectance graph for the EUV wavelength repeat at a period of about 7nm, which is the half-wavelength (λ/2).

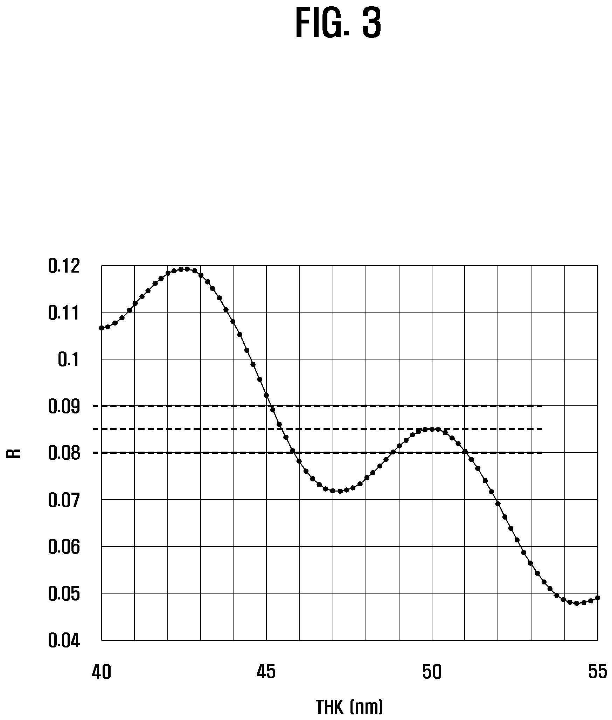

FIG. 3 to FIG. 5 are diagrams specifically explaining the embodiment of this invention. The embodiment of this invention was implemented with the goal of forming the phase shift film 108 with a material containing a composition ratio of Cr:Nb = 6:4. However, this embodiment also applies to cases where the phase shift film 108 has a composition ratio of Cr:Nb = 6.5:3.5 ~ 5.5:4.5, which includes the composition ratio of Cr:Nb = 6:4, and substantially the same results are obtained within this range. When actually implementing a film with a composition ratio of Cr:Nb = 6:4, a film with a range of Cr:Nb = 6.5:3.5 ~ 5.5:4.5 is obtained due to manufacturing process tolerances. The embodiment was configured to satisfy the requirements of this invention as described above in terms of the composition of each layer, extinction coefficient (k), and other properties.

FIG. 3 is a diagram illustrating the change in reflectance (R) with respect to the thickness of the phase shift film 108 containing a composition ratio of Cr:Nb = 6.5:3.5 ~ 5.5:4.5. The reflectance (R) in FIG. 3 is also the reflectance in the stacked structure 108 and 109 of the phase shift film 108 and the 2nm thick TaO hard mask film 109. Referring to the graph in FIG. 3, as in the case of FIG. 2, the reflectance decreases as the thickness of the phase shift film 108 increases, but the overall change shows a pattern of decreasing in the form of a wave with a period of about 7nm, which is the half-wavelength (λ/2) of the 13.5nm wavelength EUV exposure light.

In FIG. 3, the thickness of the phase shift film 108 that yields a reflectance of less than 9% is a thickness exceeding 45nm, and a reflectance of less than 9% is obtained in all thickness ranges exceeding 45nm. However, if the phase shift film 108 becomes too thick, a shadowing effect problem occurs. Therefore, the phase shift film 108 preferably has a thickness of less than 55nm. In this case, the thickness of the stacked structure 108 and 109 becomes less than 57nm, so there is no shadowing effect problem.

Meanwhile, the above thickness range of exceeding 45nm and less than 55nm only considers the aspects of relative reflectance less than 9% and prevention of shadowing effect. However, as the thickness of the phase shift film 108 increases, the NILS in the stacked structure 108 and 109 deteriorates, so additional restrictions on the thickness of the phase shift film 108 must be imposed to obtain a good NILS value.

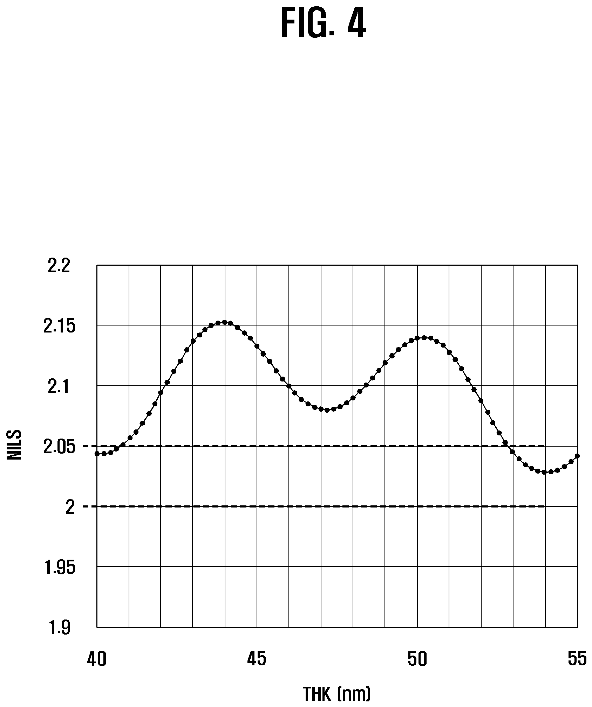

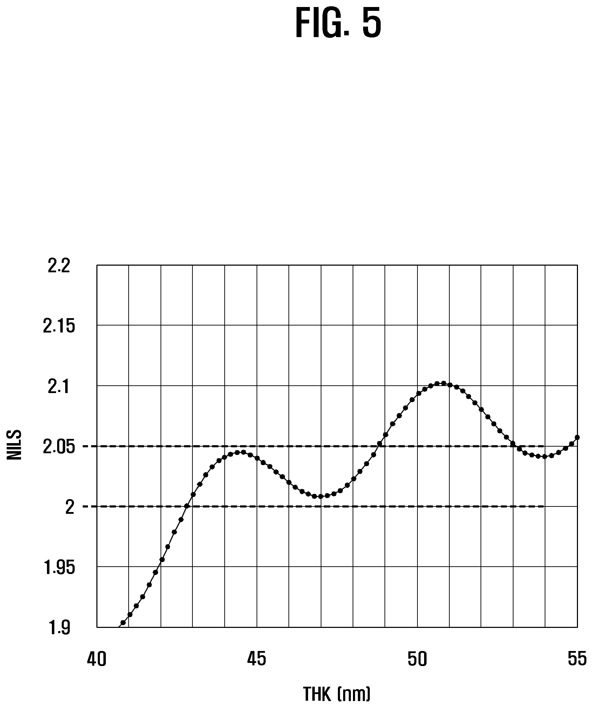

FIG. 4 is a graph showing the NILS measured in the horizontal direction of the stacked structure 108 and 109 under the same conditions as in FIG. 3, and FIG. 5 is a graph showing the NILS measured in the vertical direction of the stacked structure 108 and 109 under the same conditions as in FIG. 3. Here, the horizontal direction means the direction in which the pattern of the phase shift film 108 is parallel to the inclined direction of the incident exposure light, i.e., the direction in which the shadowing effect is small, and the vertical direction means the direction in which the pattern of the phase shift film 108 is perpendicular to the inclined direction of the incident exposure light, i.e., the direction in which the shadowing effect is large. In FIG. 4 and FIG. 5, the horizontal axis is the same as in FIG. 3, and the vertical axis represents the NILS value.

The higher the NILS value, the better the performance of the photomask, and generally, 2.0 or higher is required. As can be seen from FIG. 4 and FIG. 5, the NILS is 2.0 or higher in all thickness ranges of 45~55nm where the reflectance (R) becomes less than 9% in FIG. 3, so this thickness range also satisfies the NILS requirement. If a better NILS of 2.05 or higher is required, the thickness range of the phase shift film 108 can be further restricted. Referring to FIG. 4, in the horizontal direction, the NILS of 2.05 or higher is obtained when the thickness is less than 52.8nm, and referring to FIG. 5, in the vertical direction, the NILS of 2.05 or higher is obtained when the thickness exceeds 48.8nm and is less than 53nm. Photomasks can be used only for pattern formation in the horizontal direction depending on their use, so cases where only the NILS in the horizontal direction is 2.05 or higher can also be meaningful. Therefore, if a better NILS is required only in the horizontal direction, the thickness of the phase shift film 108 can be additionally restricted to less than 52.8nm, and if a better NILS is required in both the horizontal and vertical directions, the thickness of the phase shift film 108 can be additionally restricted to exceeding 48.8nm and less than 52.8nm.

As mentioned earlier, in logic applications, the reflectance must be at least less than 9%, and if it is less than 8.5%, it is more useful than this, and if it is less than 8%, it is even more useful. Such more restricted reflectance (R) can be obtained by further restricting the thickness of the phase shift film 108.

As can be seen in FIG. 3, if a reflectance of less than 8.5% is required, the phase shift film 108 must have a thickness exceeding 45.5nm. Therefore, the thickness of the phase shift film 108 that yields a reflectance of less than 8.5%, considering the shadowing effect, becomes a range exceeding 45.5nm and less than 55nm.

As confirmed in FIG. 3, if a reflectance of less than 8% is required, the phase shift film 108 must have a thickness exceeding 45.8nm. Therefore, the thickness of the phase shift film 108 that yields a reflectance of less than 8%, considering the shadowing effect, becomes a range exceeding 45.8nm and less than 55nm. However, according to FIG. 3, in the range of 48.8~51nm, it shows a reflectance somewhat exceeding 8%. In the actual wafer exposure process related to the required reflectance range, some error is allowed, so exceeding 8% in some ranges is generally not a problem. Therefore, even if a reflectance of less than 8% is required, it is acceptable to set a thickness range exceeding 45.8nm and less than 55nm. However, if a reflectance of less than 8% is strictly required, it is preferable to exclude the range showing such an error. Therefore, considering this, the preferable range is set to a range exceeding 45.8nm and less than 48.8nm or a range exceeding 51nm and less than 55nm. When considering reflectance and NILS, either of these two ranges can be adopted, but depending on other requirements, one of these two ranges that is advantageous can be selected.

The range for meeting the NILS requirements as described above for the case where a reflectance of less than 9% is required, for both the requirement of NILS 2.0 or higher and the requirement of NILS 2.05 or higher, is included within the range of 45.5~55nm for a reflectance of less than 8.5% and the range of 45.8~55nm for a reflectance of 8%. Therefore, the thickness of the phase shift film 108 in the case where the required NILS requirement is strengthened is the same as in the case of 9% for both cases where the required reflectance is 8.5% and 8%. Therefore, the thickness range set considering NILS for the reflectance requirement of less than 9% as described above applies equally to the cases of less than 8.5% and less than 8%.

Meanwhile, in the above embodiment, the upper limit of the thickness of the phase shift film 108 considering the shadowing effect was set to 55nm. This thickness prevents the shadowing effect because it is lower than 60nm even when adding the thickness of the hard mask film 109 of 2nm. However, the shadowing effect prevention effect increases as the thickness decreases, so considering this, an even smaller thickness can be set. For example, if the thickness of the phase shift film 108 is less than 50nm, the shadowing effect prevention effect becomes even greater.

As described above, the above embodiment assumes that the pattern of the hard mask film 109 containing TaO and having a thickness of 2nm on top of the phase shift film 108 remains in the photomask. Therefore, if the blankmask is formed without the hard mask film 109 itself, or if the hard mask film 109 is removed after etching the phase shift film 108 so that it does not remain in the photomask, the thickness of the phase shift film 108 should be increased compared to the above embodiment.

As explained above regarding the composition of the hard mask film 109, the hard mask film 109 must have a high content of oxygen (O) to be etched by fluorine-based etching gas, and accordingly, it has a low content of Ta, making its extinction coefficient (k) similar to that of the phase shift film 108. Therefore, in the absence of the hard mask film 109, the thickness to be increased at the phase shift film 108 is substantially the same with the thickness of the hard mask film 109.

Specifically, when the hard mask film 109 is excluded, if the requirement for the reflectance of the phase shift film 108 is less than 9%, the thickness of the phase shift film 108 is exceeding 47nm and less than 57nm; if it is less than 8.5%, the thickness of the phase shift film 108 is exceeding 47.5nm and less than 57nm; and if it is less than 8%, the thickness of the phase shift film 108 is exceeding 47.8nm and less than 57nm. If it is desired to exclude the range showing error for the case of less than 8%, the thickness of the phase shift film 108 is a thickness exceeding 47.8nm and less than 50.8nm or a thickness exceeding 53nm and less than 57nm.

When considering NILS for the case where the hard mask film 109 is excluded, the NILS requirement of 2.0 or higher is satisfied at all these thicknesses. When considering NILS of 2.05 or higher, if NILS of 2.05 or higher is required only in the horizontal direction, an additional restriction of less than 54.8nm is imposed on the above thickness of the phase shift film 108, and if NILS of 2.05 or higher is required in both the horizontal and vertical directions, an additional restriction of exceeding 50.8nm is imposed on the above thickness of the phase shift film 108.

These thicknesses are for the case where the thickness of the hard mask film 109 in the first embodiment is 2nm, but these values also apply to a thickness range of 2±1nm, considering the deviation in the manufacturing process of the hard mask film 109.

Meanwhile, as in the previously described embodiment, even when the hard mask film 109 is excluded, the thickness of the phase shift film 108 can be made to be less than 52nm by reducing the upper limit from the above numerical range. This further improves the shadowing effect prevention effect. As a modification of this invention, an additional hard mask film (not shown) that is etched by chlorine-based etching gas can be formed on top of the hard mask film 109. As an example, the additional hard mask film can be formed of a material containing CrNb, preferably CrNbON. The TaO hard mask film 109 of this invention is etched by fluorine-based etching gas, and damage occurs to the resist film 110 during etching by fluorine-based etching gas. Therefore, the thickness of the resist film 110 must be increased for etching the TaO hard mask film 109. In cases where a thin resist film 110 is to be adopted, the thickness of the TaO hard mask film 109 must be thin, and in this case, the hard mask film 109 may be insufficient to be used as an etching mask for the phase shift film 108 below it. Adding a CrNbON hard mask film on top of the TaO hard mask film 109 can solve this problem. In this case, after patterning the CrNbON hard mask film with chlorine-based etching gas using the pattern of the resist film 110, the TaO hard mask film 109 is etched with fluorine-based etching gas. The pattern of the TaO hard mask film 109 and the pattern of the CrNbON hard mask film are used together as an etching mask for patterning the phase shift film 108. The pattern of the CrNbON hard mask film does not remain in the photomask and is removed. Since the phase shift film 108 is etched by chlorine-based etching gas, the pattern of the CrNbON hard mask film is removed during the etching process of the phase shift film 108. Therefore, the CrNbON hard mask film does not affect the configuration of the phase shift film 108 and the hard mask film 109 of this invention.

Although details of the disclosure have been described above through a few embodiments of the disclosure with reference to the accompanying drawings, the embodiments are merely for the illustrative and descriptive purposes only but not construed as limiting the scope of the disclosure defined in the appended claims. It will be understood by a person having ordinary skill in the art that various changes and other equivalent embodiments may be made from these embodiments. Thus, the scope of the invention should be defined by the technical subject matters of the appended claims.

## Claims

1. A phase shift blankmask for extreme ultraviolet lithography comprising:
a substrate;
a reflective film formed on the substrate;
a capping film formed on the reflective film; and
a phase shift film formed on the capping film,
wherein the phase shift film,
consists of a single layer containing chromium (Cr), niobium (Nb), and nitrogen (N),
has a composition ratio of Cr:Nb = 6.5:3.5 ~ 5.5:4.5, and
has an extinction coefficient (k) exceeding 0.023 and a relative reflectance of less than 9% for an EUV wavelength of 13.5nm.

2. The phase shift blankmask of claim 1, wherein the phase shift film has a total content of Cr and Nb exceeding 60at% and less than 90at%, and has a nitrogen (N) content exceeding 10at% and less than 40at%.

3. The phase shift blankmask of claim 1, wherein the phase shift film further contains oxygen (O), has a total content of Cr and Nb exceeding 50at% and less than 80at%, has a nitrogen (N) content exceeding 10at% and less than 30at%, and has an oxygen (O) content exceeding 10at% and less than 20at%.

4. The phase shift blankmask of any one of claims 1 to 3, wherein the phase shift film has a thickness exceeding 47nm and less than 57nm.

5. The phase shift blankmask of claim 4, wherein the phase shift film has a thickness exceeding 50.8nm and less than 54.8nm.

6. The phase shift blankmask of any one of claims 1 to 3, wherein the relative reflectance is less than 8.5%, and the phase shift film has a thickness exceeding 47.5nm and less than 57nm.

7. The phase shift blankmask of claim 6, wherein the phase shift film has a thickness exceeding 50.8nm less than 54.8nm.

8. The phase shift blankmask of any one of claims 1 to 3, wherein the relative reflectance is less than 8%, and the phase shift film has a thickness exceeding 47.8nm and less than 57nm.

9. The phase shift blankmask of claim 8, wherein the phase shift film has a thickness exceeding 50.8nm and less than 54.8nm.

10. The phase shift blankmask of any one of claims 1 to 3, further comprising a hard mask film formed on the phase shift film, containing tantalum (Ta) and oxygen (O), having a Ta content of less than 50at%, having an extinction coefficient (k) exceeding 0.020, and having a thickness of 2±1nm.

11. The phase shift blankmask of claim 10, wherein the phase shift film has a thickness exceeding 45nm and less than 55nm.

12. The phase shift blankmask of claim 11, wherein the phase shift film has a thickness exceeding 48.8nm and less than 52.8nm.

13. The phase shift blankmask of claim 10, wherein the relative reflectance is less than 8.5%, and the phase shift film has a thickness exceeding 45.5nm and less than 55nm.

14. The phase shift blankmask of claim 13 wherein the phase shift film has a thickness exceeding 48.8nm and less than 52.8nm.

15. The phase shift blankmask of claim 10, wherein the relative reflectance is less than 8%, and the phase shift film has a thickness exceeding 45.8nm and less than 55nm

16. The phase shift blankmask of claim 15, wherein the phase shift film has a thickness exceeding 48.8nm and less than 52.8nm.

17. A photomask fabricated using the phase shift blankmask for extreme ultraviolet lithography of any one of claims 1 to 16.
